# EUROPÄISCHE PATENTANMELDUNG

(11) **EP 1 187 191 A2**
(43) Veröffentlichungstag der Anmeldung: **13.03.2002**
(21) Anmeldenummer: 01119173.1
(22) Anmeldetag: 08.08.2001
(51) Int. Cl.: H01L 21/762, H01L 21/8242, H01L 27/108

(54) **SOI-Substrat sowie darin ausgebildete Halbleiterschaltung und dazugehörige Herstellungsverfahren**

(30) Priorität: 27.08.2000 DE 10041748
(71) Anmelder: Infineon Technologies AG, 81669 München (DE)
(72) Erfinder: Lützen, Jörn, Dr., 01099 Dresden (DE); Sell, Bernhard, 01099 Dresden (DE)
(74) Vertreter: Kindermann, Peter, Dipl.-Ing.

(57) **Zusammenfassung**

Die vorliegende Erfindung betrifft ein SOI-Substrat (1, 2, 3) sowie eine darin ausgebildete Halbleiterschaltung (AT, C, K) und dazugehörige Herstellungsverfahren, bei dem unter Verwendung einer Multilayer-Barrierenschicht (2) mit einer Potentialbarriere und einer Diffusionsbarriere eine Diffusion von Verunreinigungen zuverlässig zwischen Elementschichten (1, 3) verhindert wird. Auf diese Weise können Halbleiterschaltungen mit kleineren Strukturgrößen und höherer Integrationsdichte realisiert werden.

## Beschreibung

Die vorliegende Erfindung bezieht sich auf ein SOI-Substrat sowie eine darin ausgebildete Halbleiterschaltung und dazugehörige Herstellungsverfahren und insbesondere auf ein SOI-Substrat mit einer speziellen Multilayer-Barrierenschicht zur Realisierung einer Vielzahl von Elementschichten.

SOI-Substrate (silicon on insulator) werden als Ausgangsmaterial auf dem Gebiet der Halbleitertechnik seit langer Zeit verwendet. Der Vorteil bei der Verwendung von derartigen SOI-Substraten liegt einerseits in einer verbesserten Unempfindlichkeit gegenüber Strahlungseinflüssen (silicon on saphire) und der Möglichkeit für den Einsatz von geringeren Spannungen als sie bei herkömmlichen Siliziumsubstraten verwendet werden können. Insbesondere bei der Herstellung von Halbleiterschaltungen mit Halbleiterelementen in unterschiedlichen Elementschichten, wie sie beispielsweise aus der Druckschrift US 5,508,219 anhand eines SOI-DRAMs beschrieben ist, ergeben sich beim Einsatz neuartiger Materialien oftmals Probleme dahingehend, dass auf Grund einer Inkompatibilität mit dem Halbleitermaterial des SOI-Substrats die charakteristischen Eigenschaften der Halbleiterelemente gestört bzw. verschlechtert werden.

Der Erfindung liegt daher die Aufgabe zu Grunde ein SOI-Substrat, ein dazugehöriges Herstellungsverfahren sowie eine darin ausgebildete Halbleiterschaltung mit dazugehörigem Herstellungsverfahren zu schaffen, bei dem auf einfache und kostengünstige Weise eine gegenseitige Störung auf Grund der verwendeten Materialien verhindert wird.

Erfindungsgemäß wird diese Aufgabe hinsichtlich des SOI-Substrats durch die Merkmale des Patentanspruchs 1, hinsichtlich des dazugehörigen Herstellungsverfahrens durch die Maßnahmen des Patentanspruchs 8, hinsichtlich der darin ausgebildeten Halbleiterschaltung durch die Merkmale des Patentanspruchs 13 und hinsichtlich des dazugehörigen Herstellungsverfahrens durch die Maßnahmen des Patentanspruchs 15 gelöst.

Insbesondere durch die Verwendung einer Isolationsschicht, welche eine Multilayer-Barrierenschicht mit einer Potentialbarriere und einer Diffusionsbarriere aufweist, verhindert das erfindungsgemäße SOI-Substrat nicht nur zuverlässig das Auftreten von Leckströmen, sondern ermöglicht auch den Einsatz neuer Materialien zum Ausbilden von Halbleiterelementen in einer weiteren Elementschicht des Halbleitersubstrats. Insbesondere eine Diffusion von Verunreinigungen bzw. Elementen der neuen Materialien in eine der Elementschichten kann somit zuverlässig verhindert werden, wodurch die Halbleiterelemente entkoppelt bzw. nicht gestört werden.

Vorzugsweise besteht die Multilayer-Barrierenschicht aus einer Vielzahl von verschiedenen Isolationsschichten, welche unterschiedliche Potential- und Diffusionsbarrieren aufweisen. Sie kann jedoch auch aus zumindest einer Isolationsschicht und zumindest einer leitenden Schicht bestehen, wodurch sich spezielle Halbleiterschaltungen wesentlich verbessern bzw. vereinfachen lassen.

Durch Verwendung einer isolierenden Schicht, einer halbleitenden Schicht oder einer leitenden Schicht für die weitere Elementschicht bzw. Trägerschicht kann für jedes Anwendungsgebiet ein optimales SOI-Substrat geschaffen werden.

Vorzugsweise besitzt die Multilayer-Barrierenschicht ferner eine Thermo-Kompensationsschicht, wodurch die bei einer Temperaturbehandlung auftretenden Spannungen insbesondere bei Verwendung von unterschiedlichen Materialien ausgeglichen werden können.

Eine in einem derartigen SOI-Substrat ausgebildete Halbleiterschaltung besteht vorzugsweise aus einem ersten und zweiten Halbleiterelement, welche in der ersten und zweiten Elementschicht ausgebildet sind und über eine leitende Diffusionsbarrierenschicht elektrisch miteinander verbunden sind. Auf diese Weise kann eine Ausdiffusion von inkompatiblen Materialien über die notwendigen Anschlussbahnen verhindert werden, wodurch eine gegenseitige negative Beeinflussung der Elemente in den unterschiedlichen Elementschichten während eines Herstellungsprozesses oder in Betrieb verhindert werden kann.

Die Halbleiterschaltung kann beispielsweise eine DRAM-Speicherschaltung darstellen, wobei die Halbleiterelemente in der ersten Elementschicht Auswahltransistoren und die Halbleiterelemente in der zweiten Elementschicht Grabenkondensatoren darstellen. Bei derartigen Halbleiterschaltungen können bisher nicht erreichte Integrationsdichten auf Grund des Einsatzes von nunmehr möglichen neuen Materialien realisiert werden, wodurch sich eine Speicherkapazität pro Chipfläche wesentlich vergrößert.

In den weiteren Ansprüchen sind weitere vorteilhafte Ausgestaltungen der Erfindung gekennzeichnet.

Die Erfindung wird nachstehend anhand von Ausführungsbeispielen unter Bezugnahme auf die Zeichnung näher beschrieben.

Es zeigen:
Figuren 1A bis 1C vereinfachte Schnittansichten des erfindungsgemäßen SOI-Substrats zur Veranschaulichung von dazugehörigen Herstellungsschritten,
Figuren 2A bis 2N vereinfachte Schnittansichten zur Veranschaulichung eines Herstellungsverfahrens einer DRAM-Speicherzelle gemäß einem ersten Ausführungsbeispiel;
Figuren 3A bis 3L vereinfachte Schnittansichten zur Veranschaulichung eines Herstellungsverfahrens einer DRAM-Speicherzelle gemäß einem zweiten Ausführungsbeispiel;
Figuren 4A und 4B vereinfachte Schnittansichten zur Veranschaulichung eines Herstellungsverfahrens für einen Kontaktanschluss der in Figur 2N dargestellten DRAM-Speicherzelle; und
Figur 5 ein Ersatzschaltbild der in Figur 4B dargestellten DRAM-Speicherzelle.

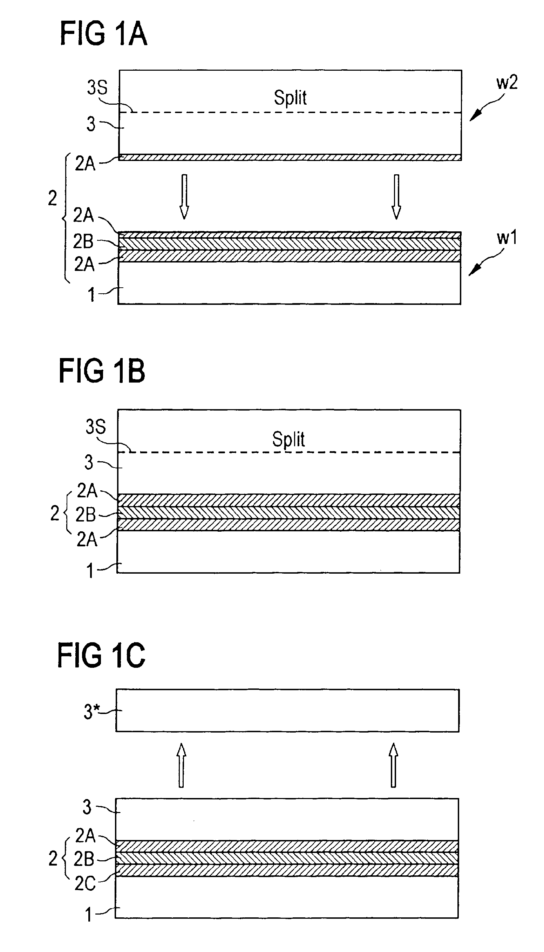

Figuren 1A bis 1C zeigen vereinfachte Schnittansichten von wesentlichen Verfahrensschritten bei der Herstellung des erfindungsgemäßen SOI-Substrats. Das Verfahren entspricht hierbei einem Herstellungsverfahren für herkömmliche SOI-Substrate, weshalb auf eine detaillierte Beschreibung von herkömmlichen Verfahrensschritten nachfolgend verzichtet wird.

Gemäß Figur 1A wird zunächst ein erster Wafer bzw. Trägerwafer (support wafer) W1 mit zumindest einem Teil einer Multilayer-Barrierenschicht 2 versehen. Genauer gesagt wird beispielsweise gemäß Figur 1A eine SiO₂-Schicht 2A abgeschieden oder thermisch ausgebildet, welche im Wesentlichen als Potentialbarriere und somit zur elektrischen Isolation dient. Darauf wird anschließend eine elektrisch isolierende Diffusionsbarrierenschicht 2B ausgebildet, die beispielsweise aus einer Si₃N₄-Schicht besteht. Diese Diffusionsbarrierenschicht 2B dient neben ihrer isolierenden Funktion im Wesentlichen als Diffusionsbarriere zur Verhinderung einer Diffusion von Verunreinigungen wie sie beim Einsatz von neuartigen Materialien auftreten. Anschließend wird die bereits ausgebildete Multilayer-Barrierenschicht noch mal oxidiert oder eine Oxidschicht abgeschieden, wodurch die weitere SiO₂-Schicht 2A auf dem Trägerwafer W1 ausgebildet wird.

Ferner wird ein zweiter Wafer W2 (donar wafer) zur Ausbildung einer Abspalt-Grenzschicht 3S beispielsweise mit einer H-Implantation versehen und darüber hinaus an seiner Oberfläche oxidiert bzw. mit einer dünnen SiO₂-Schicht 2A versehen. Vorzugsweise bestehen die Wafer W1 und W2 aus einem Halbleitersubstrat wie Si, wobei jedoch auch jedes andere Halbleitermaterial verwendet werden kann.

Gemäß Figur 1B wird in einem nachfolgenden Verfahrensschritt der erste (Träger-)Wafer W1 mit dem zweiten Wafer W2 an seinen oxidierten Oberflächen mittels bekannter Waferbondingverfahren verbunden. Insbesondere auf Grund der Verwendung von gleichen Isolationsschichten 2A am ersten Wafer W1 und am zweiten Wafer W2 ergibt sich dadurch eine sehr einfache und stabile Verbindung.

Gemäß Fig 1C erfolgt die Trennung des oberen Teils 3* des Halbleitersubstrates 3 mittels einer thermischen Behandlung, die dazu führt, dass der Wafer entlang der implantierten Abspalt-Grenzschicht (vorzugsweise Wassserstoff) abplatzt/gespalten wird. Auf diese Weise erhält man das in Figur 1C dargestellte verbleibende SOI-Substrat mit seiner ersten Halbleiterschicht bzw. Elementschicht 3, seiner Multilayer-Barrierenschicht 2 und der zweiten Elementschicht bzw. Trägerschicht 1. Auf Grund der speziellen Zusammensetzung der Multilayer-Barrierenschicht aus Schichten, welche eine Diffusionsbarriere darstellen und Schichten, welche eine Potentialbarriere darstellen, können nunmehr auch inkompatible Materialien bei der Herstellung von Halbleiterschaltungen verwendet werden.

Derartige neue Materialien sind beispielsweise für den Einsatz von Dielektrika Al₂O₃, TiO₂, Ta₂O₅, ZrO₂, HfO₂, La₂O₃, ZrSiₓO_{y}, HfSiₓO_{y}. Als Barrieren bzw. Elektrodenschichten können darüber hinaus nunmehr TiN, WN, TaN usw. verwendet werden. Ferner können als Elektrodenschichten Ti, W, Ta, Si (dotiert mit beispielsweise B, P, As, usw.), TaSiN, TiSi, TaSi, CoSi, MoSi, WSiₓ, WSiₓN_{y}, PT, Ru, RuO und Ir verwendet werden. Die vorstehend genannten Materialien sind lediglich Beispiele, wobei sich jedoch die vorliegende Erfindung nicht auf diese beschränkt. Auf Grund der verwendeten Multilayer-Barrierenschicht 2 ergibt sich jedoch eine vollständige elektrische und materialtechnische Trennung der beiden Elementschichten 1 und 3, weshalb darin ausgebildete Halbleiterelemente keinerlei Beeinflussung durch die üblicherweise potentiell störenden neuen Materialien erfahren.

Ferner kann die Multilayer-Barrierenschicht 2 eine nicht dargestellte leitende, halbleitende oder isolierende Thermo-Kompensationsschicht aufweisen, wodurch die bei Verwendung von unterschiedlichen Substratmaterialien auftretenden (Wärme-)Spannungen ausgeglichen werden können.

Gemäß Figuren 1A bis 1C wurde für den ersten Wafer W1 ein Halbleiterwafer mit einem Halbleitersubstrat 1 als Trägerschicht verwendet. Die Erfindung ist jedoch nicht darauf beschränkt und bezieht sich vielmehr auch auf derartige Wafer, bei denen die Trägerschicht bzw. Elementschicht 1 aus einem leitenden, einem halbleitenden oder einem isolierenden Material besteht. In gleicher Weise beschränkt sich das erfindungsgemäße SOI-Substrat auch nicht auf eine rein isolierende Multilayer-Barrierenschicht 2, sondern umfasst Multilayer-Barrierenschichten, welche beispielsweise aus einer später beschriebenen Isolationsschicht und einer leitenden Schicht bestehen.

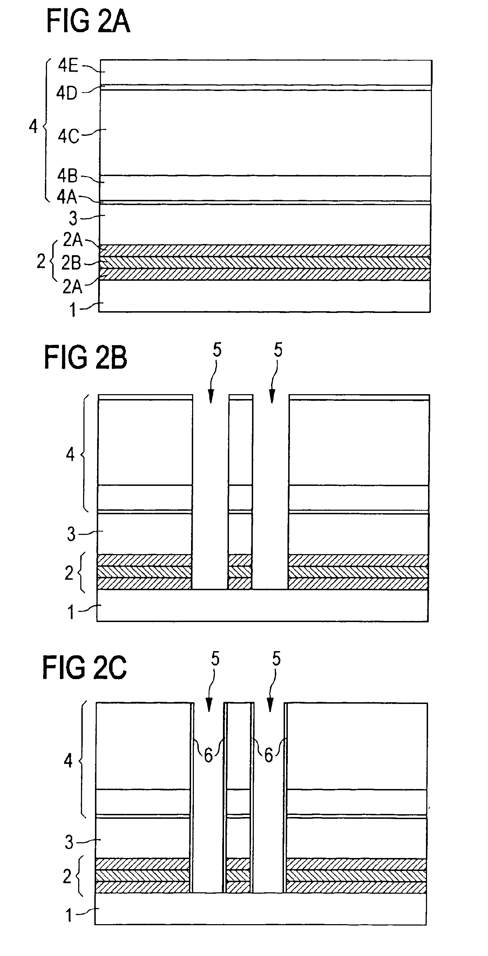

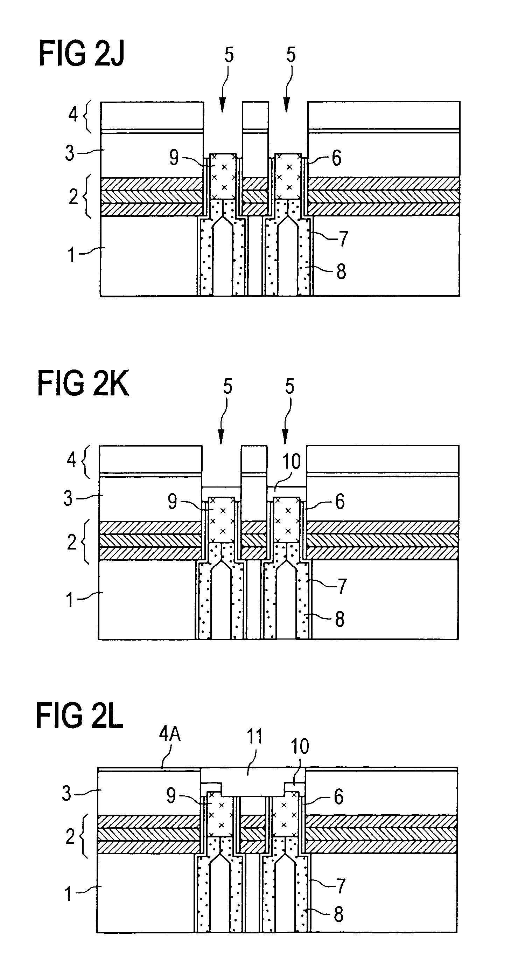

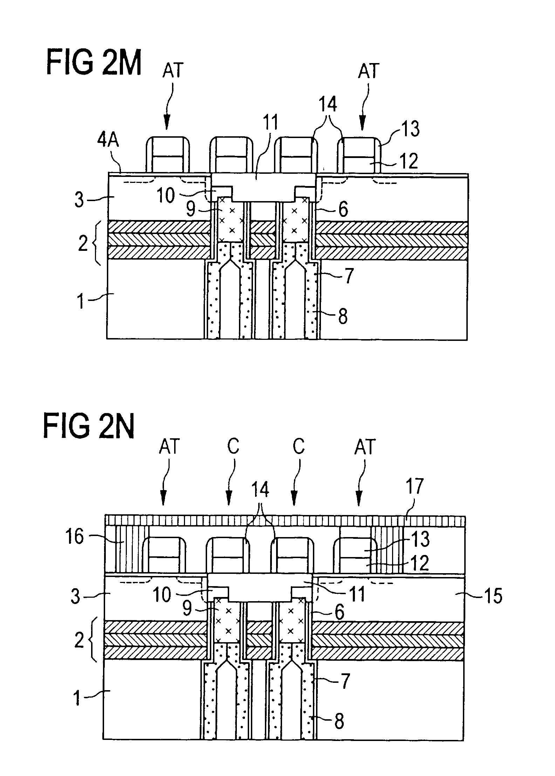

Figuren 2A bis 2N zeigen vereinfachte Schnittansichten zur Veranschaulichung von Verfahrensschritten zur Herstellung einer Halbleiterschaltung gemäß einem ersten Ausführungsbeispiel. Gleiche Bezugszeichen bezeichnen hierbei gleiche oder ähnliche Schichten, weshalb auf eine wiederholte Beschreibung nachfolgend verzichtet wird.

Gemäß Figur 2A wird beispielsweise als SOI-Substrat ein Ausgangsmaterial mit einer 10 nm dicken Oxidschicht 2A, einer 100 nm dicken Nitridschicht 2B und einer 100 nm dicken Oxidschicht 2A ausgegangen, auf der sich eine 400 nm dicke Si-Schicht als erste Elementschicht 3 befindet und gemeinsam mit der Trägerschicht bzw. der zweiten Elementschicht 1 das Ausgangsmaterial darstellt. Zur Realisierung einer insbesondere der Multilayer-Barrierenschicht 2 entsprechenden Maske wird auf das SOI-Substrat eine Maskenschicht 4 aufgebracht, die gemäß Figur 2A aus einer sehr dünnen Oxidationsschicht 4A, einer Pad-Nitridschicht 4B, einer Borsilikatglas-Schicht (BSG) 4C, einer Nitridschicht 4D und einer Poly-Hartmaske 4E besteht. Es sei darauf hingewiesen, dass bei Verwendung von anderen SOI-Substraten entsprechend andere Maskenschichten 4 verwendet werden müssen.

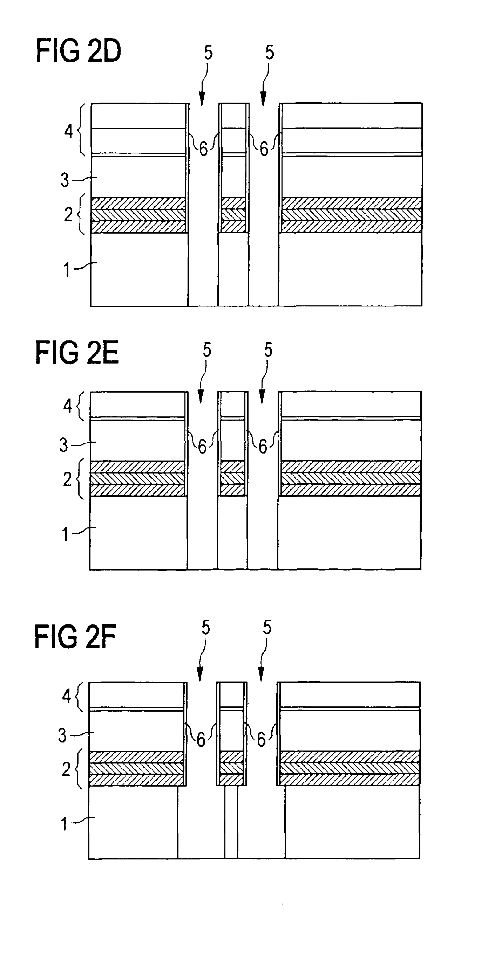

Gemäß Figur 2B wird nachfolgend in einem herkömmlichen lithografischen Verfahren eine Struktur für einen Graben 5 ausgebildet und beispielsweise mit einem Plasmaätzverfahren die Poly-Hartmaskenschicht 4E geätzt. Anschließend erfolgt ein Entfernen des Resists mit einer nachfolgenden Plasmaätzung der Nitridschicht 4D, der Borsilikatglas-Schicht 4C, der Nitridschicht 4B und der Oxidschicht 4A. Unter Verwendung der Nitridschicht 4D als Maske wird nunmehr beispielsweise mittels Plasmaätzen die 400 nm dicke Si-Schicht bzw. erste Elementschicht 3 geätzt und ferner die Oxidschicht 2A, die Nitridschicht 2B und die Oxidschicht 2A der Multilayer-Barrierenschicht 2 entfernt. Gemäß Figur 2C wird anschließend an den Wänden der Gräben 5 eine ca. 10 nm dicke Si₃N₄-Schicht 6 als Nitridliner abgeschieden, der sowohl als Ätzmaske als auch als Diffusionsbarriere für spätere Verfahrensschritte wirkt. Ferner wird vorzugsweise durch ein anisotropes Ätzverfahren die an den horizontalen Flächen abgeschiedene Nitridschicht 6 wieder entfernt. Gemäß Figur 2D wird nunmehr der eigentliche tiefe Graben 5 in die Trägerschicht 1 bzw. weitere Elementschicht geätzt und gemäß Figur 2E die verbliebene BSG-Schicht 4C entfernt.

Gemäß Figur 2F kann optional in einem nachfolgenden Schritt ein unterer Bereich des Grabens 5 unter Verwendung der Si₃N₄-Schicht 6 als Maske aufgeweitet werden, wodurch sich beispielsweise eine Vergrößerung einer Kapazität eines Grabenkondensators realisieren lässt. Vorzugsweise erfolgt dieses Erweitern mittels eines Nassätzverfahrens.

Die Dotierung des Substrates im Bereich um den unteren Teil des Grabens erfolgt vorzugsweise mittels Gasphasendotierung (GPD). Andere Verfahren können zum Einsatz kommen.

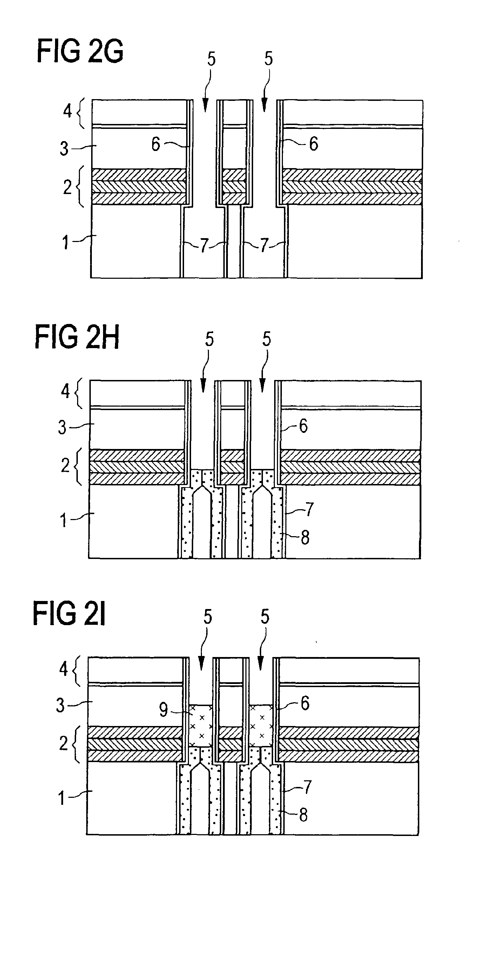

Gemäß Figur 2G wird nunmehr ein Kondensatordielektrikum 7 an der Oberfläche des Grabens 5 ausgebildet, wobei beispielsweise oxidiertes Nitrid verwendet werden kann. Vorzugsweise können für dieses Dielektrikum jedoch nunmehr auch Materialien verwendet werden, die bisher als inkompatibel zu herkömmlichen Siliziumprozessen galten, wie z.B. die vorstehend genannten Dielektrika und insbesondere Dielektrika mit hoher relativer Dielektrizitätskonstante. Auf Grund des verwendeten SOI-Substrats mit seiner als Potentialbarriere und Diffusionsbarriere wirkenden Multilayer-Barrierenschicht 2 können derartige Materialien nunmehr nicht länger von der Elementschicht 1 in die Elementschicht 3 gelangen.

Gemäß Figur 2H wird nach Ausbildung einer nicht dargestellten vergrabenen Platte als Gegenelektrode eine innere Elektrodenschicht 8 im Graben 5 ausgebildet und bis zu einer vorbestimmten Höhe innerhalb der Multilayer-Barrierenschicht 2 eingesenkt. Während bisher vorzugsweise Polysilizium mit seinen relativ hohem spezifischen Widerstand als Elektrodenmaterial verwendet wurde, können nunmehr neue Elektrodenmaterialien verwendet werden, die eine hohe Leitfähigkeit besitzen und darüber hinaus hervorragende Fülleigenschaften aufweisen Auch bei sehr kleinen Strukturgrößen und sehr tiefen Gräben erhält man dadurch in der weiteren Elementschicht 1 ausgebildete Halbleiterelemente bzw. Grabenkondensatoren.

Gemäß Figur 2I wird anschließend eine leitende Diffusionsbarrierenschicht 9 zum Anschließen der Elektrodenschicht 8 und zum Verhindern einer Diffusion von Verunreinigungen in die erste Elementschicht 3 ausgebildet und bis zu einer vorbestimmten Tiefe innerhalb der ersten Elementschicht 3 eingesenkt.

Gemäß Figur 2J wird anschließend das Kondensatordielektrikum 7 und die als Diffusionsbarrierenschicht 6 wirkende Si₃N₄-Schicht 6 entfernt. Auf Grund der Tatsache, dass der in der weiteren Elementschicht 1 ausgebildete Grabenkondensator nunmehr mit der leitenden Diffusionsbarrierenschicht 9 abgeschlossen ist, können weiterhin keinerlei Verunreinigungen aus dem unteren Bereich des SOI-Substrats in die erste Elementschicht 3 gelangen und dort zu Verschlechterungen oder Störungen führen.

Zur Herstellung eines optimalen Kontakts wird gemäß Figur 2K eine sogenannte BS-Implantation (buried strap) durchgeführt und eine ca. 500 nm dicke Polysiliziumschicht abgeschieden, wobei auch größere Gräben komplett gefüllt werden. Anschließend erfolgt eine BS-Polysilizium-Rückätzung zu Realisierung einer BS-Polyschicht 10, die ca. 50 nm unterhalb der Si-Oberfläche bzw. der Oxidschicht 4A liegt.

Gemäß Figur 2L werden anschließend mittels eines lithografischen Verfahrens die aktiven Bereiche festgelegt und vorzugsweise über ein Trockenätzverfahren flache Grabenisolierungen 11 (STI, shallow trench isolation) ausgebildet. Beispielsweise wird die STI-Grabenisolierung 11 mittels einer Oxidation, einer nachfolgenden Nitridabscheidung und einer darauf folgenden TEOS-Abscheidung ausgebildet, wobei mittels eines chemisch-mechanischen Polierverfahrens das abgeschiedene TEOS-Oxid teilweise wieder entfernt wird. Abschließend wird die verbleibende Nitrid-Maskenschicht 4B entfernt.

Gemäß Figur 2M werden anschließend sogenannte VT-Implantationen zum Anpassen der jeweiligen Einsatzspannungen durchgeführt und ein Gate-Dielektrikum abgeschieden oder eine Oxidation durchgeführt. Grundsätzlich kann jedoch auch die verbleibende Oxidationsmaskenschicht 4A verwendet werden. Zur Realisierung von ersten Halbleiterelementen in der ersten Elementschicht 3 erfolgt nachfolgend eine Abscheidung einer Gateschicht 12 sowie einer Gate-Isolationsschicht 13 mit nachfolgender Strukturierung und Implantation von dazugehörigen Source/Draingebieten und dem nachfolgenden Ausbilden von Spacern 14. Auf eine detaillierte Beschreibung der Herstellungsschritte für die Halbleiterelemente AT wird an dieser Stelle verzichtet, da es sich im Wesentlichen um herkömmliche Prozesse handelt.

Figur 2N zeigt eine vereinfachte Schnittansicht der auf diese Weise im erfindungsgemäßen SOI-Substrat ausgebildeten DRAM-Speicherzelle, wobei die in der ersten Elementschicht 3 ausgebildeten Halbleiterelemente bzw. Auswahltransistoren AT in einer Isolationsschicht 15 eingebettet und über eine Metallisierungsschicht 17 und Kontaktlöcher 16 angeschaltet sind.

Auf diese Weise können insbesondere bei Verwendung von neuartigen Materialien weitere shrinks durchgeführt werden, welche zu kleineren Geometrien führen, wobei weiterhin ein niedriger Reihenwiderstand bei den Grabenfüllschichten realisiert ist. Auf Grund der verwendeten Multilayer-Barrierenschicht 2 werden insbesondere bei der Herstellung von DRAM-Speicherzellen keine Isolationskrägen (collar) benötigt, da die Multilayer-Barrierenschicht 2 vertikale Leckströme zuverlässig verhindert. In gleicher Weise gelangen keinerlei Verunreinigungen von der ersten Elementschicht 3 in die weiteren Elementschichten 1, wodurch sich die charakteristischen Eigenschaften sowohl der Auswahltransistoren AT als auch der Grabenkondensatoren C verbessern. In gleicher Weise verhindert die nicht leitende Diffusionsbarrierenschicht 9 ein Ausdiffundieren von eventuell inkompatiblen Materialien aus dem Grabenkondensator C in die erste Elementschicht 3, wodurch auch bei einer elektrisch leitenden Verbindung eine zuverlässige Diffusionsbarriere geschaffen werden kann.

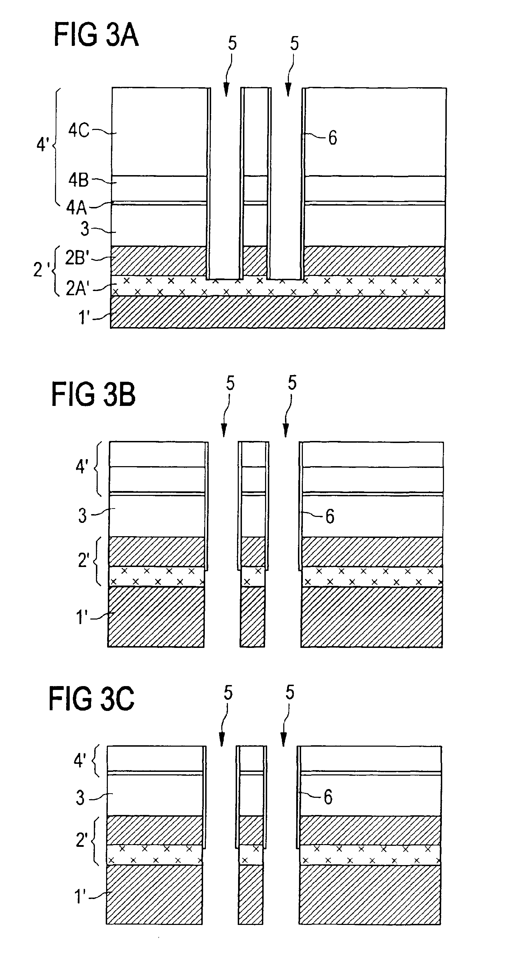

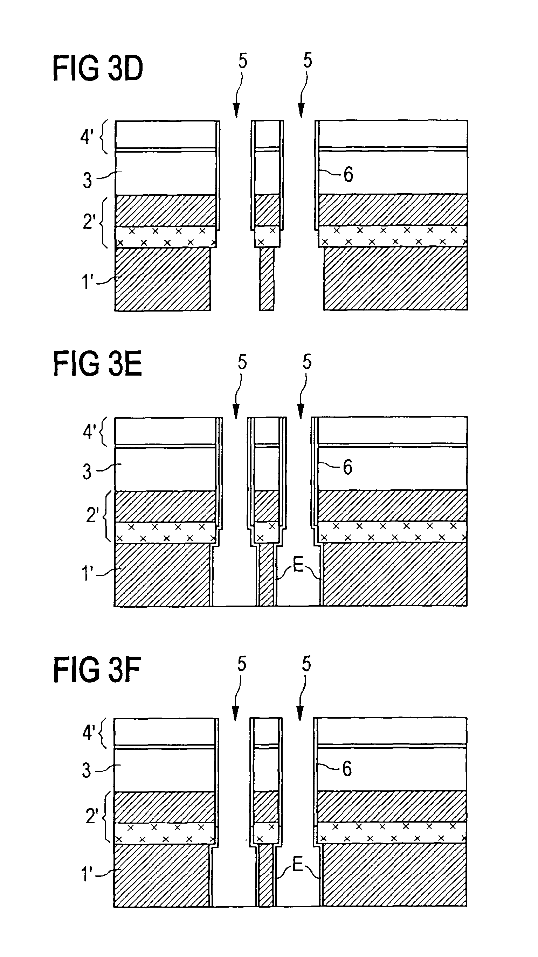

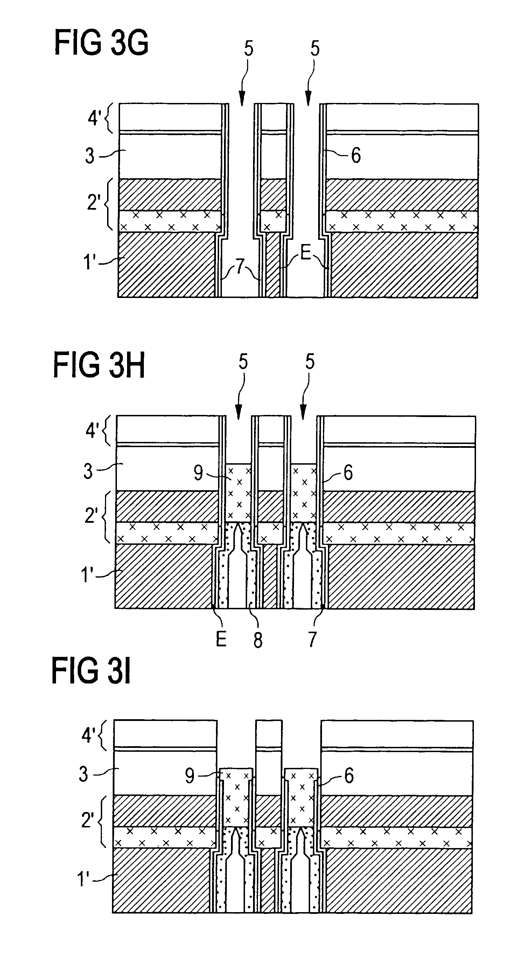

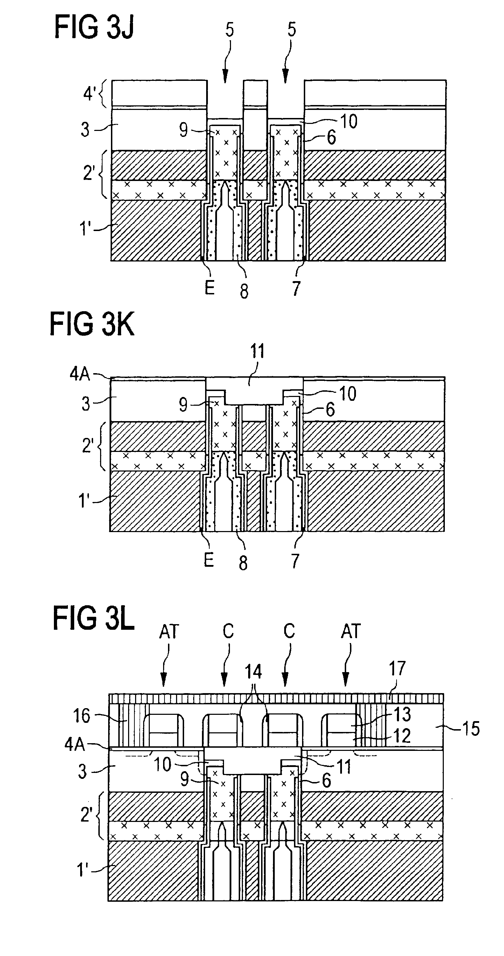

Figuren 3A bis 3L zeigen vereinfachte Schnittansichten zur Veranschaulichung von Herstellungsschritten einer DRAM-Speicherzelle gemäß einem zweiten Ausführungsbeispiel. Gleiche Bezugszeichen bezeichnen wiederum gleiche oder entsprechende Elemente bzw. Schichten, weshalb nachfolgend auf eine wiederholte Beschreibung verzichtet wird.

Gemäß Figuren 3A bis 3L besteht nunmehr das SOI-Substrat aus einer ersten Elementschicht 3, einer Multilayer-Barrierenschicht 2' und einer weiteren Elementschicht 1', wobei die weitere Elementschicht 1' nunmehr aus einem isolierenden Material wie z.B. SiO₂ besteht. Ferner besteht gemäß dem zweiten Ausführungsbeispiel die Multilayer-Barrierenschicht 2' aus einer elektrisch leitenden Diffusionsbarrierenschicht 2A' und einer elektrisch isolierenden Potentialbarrierenschicht 2B'. Die elektrisch leitende Diffusionsbarrierenschicht 2A' besteht beispielsweise wie die leitende Diffusionsbarrierenschicht 9 gemäß dem ersten Ausführungsbeispiel aus W, WN, oder WSiₓ. Sie kann jedoch auch Ti-, TiSi-, Ta-, TaN-, TiN-, Pt-, Ru-, RuO-, Ir-, Mo-, Co-, Ni-, Hf-, Zr-, NiSi-, MoN-, HfN-, MoSi-, CoSi-, TaSi-, Au-, Ag-, Cu-, Al-, WSiN-, C, Fe, oder Verbindungen aus diesen Materialien als Material aufweisen. Für den Fall, dass ein leitendes Material verwendet wird, welches keine Diffusionsbarriere darstellt, können zusätzlich weitere Schichten als Diffusionsbarrierenschichten vorgesehen werden. In gleicher Weise kann an Stelle des isolierenden Materials für die weitere Elementschicht 1' auch ein elektrisch leitendes oder halbleitendes Material verwendet werden.

Gemäß Figur 3A wird wiederum eine dem SOI-Substrat entsprechende Maskenschicht 4' mit ihren Teilschichten 4A, 4B und 4C ausgebildet und anschließend Gräben 5 sowie eine Diffusionsbarrierenschicht 6 an den Grabenwänden ausgebildet.

Gemäß Figuren 3B bis 3D wird anschließend unter Verwendung der Maskenschicht 4' der Graben 5 bis in die weitere Elementschicht 1' hinein ausgebildet und optional im unteren Bereich beispielsweise zur Vergrößerung einer Kapazität aufgeweitet. Auf eine detaillierte Beschreibung wird nachfolgend verzichtet, da sie im Wesentlichen den Schritten gemäß dem ersten Ausführungsbeispiel entsprechen.

Da jedoch beim zweiten Ausführungsbeispiel eine isolierende weitere Elementschicht 1' sowie eine Multilayer-Barrierenschicht mit einer leitenden Diffusionsbarrierenschicht 2A' verwendet wird, erfolgt im Verfahrensschritt gemäß Figur 3E eine Abscheidung einer elektrisch leitenden oder metallischen Elektrode E, die im Wesentlichen eine Außenelektrode des Grabenkondensators darstellt.

Gemäß Figuren 3F bis 3L werden nach Absenken der elektrisch leitenden Außenelektrode E anschließend entsprechend zu den Figuren 2G bis 2N wiederum ein Kondensatordielektrikum 7, eine Innenelektrode 8, eine leitende Diffusionsbarrierenschicht 9, eine BS-Polysiliziumschicht 10, eine STI-Grabenisolation 11 und die dazugehörigen Auswahltransistoren AT ausgebildet. Da die dazugehörigen Herstellungsschritte im Wesentlichen den Herstellungsschritten gemäß Figur 2 entsprechen, wird nachfolgend auf eine wiederholte Beschreibung verzichtet. Insbesondere auf Grund der Verwendung einer Multilayer-Barrierenschicht 2 mit einer Potentialbarriere und einer Diffusionsbarriere sowie einer leitenden Diffusionsbarrierenschicht 9 zum Verhindern einer Diffusion von Verunreinigungen zwischen der ersten und zweiten Elementschicht 1' und 3 können nunmehr Halbleiterschaltungen entworfen werden, die bis zu Größenordnungen kleiner 100 nm skalierbar sind.

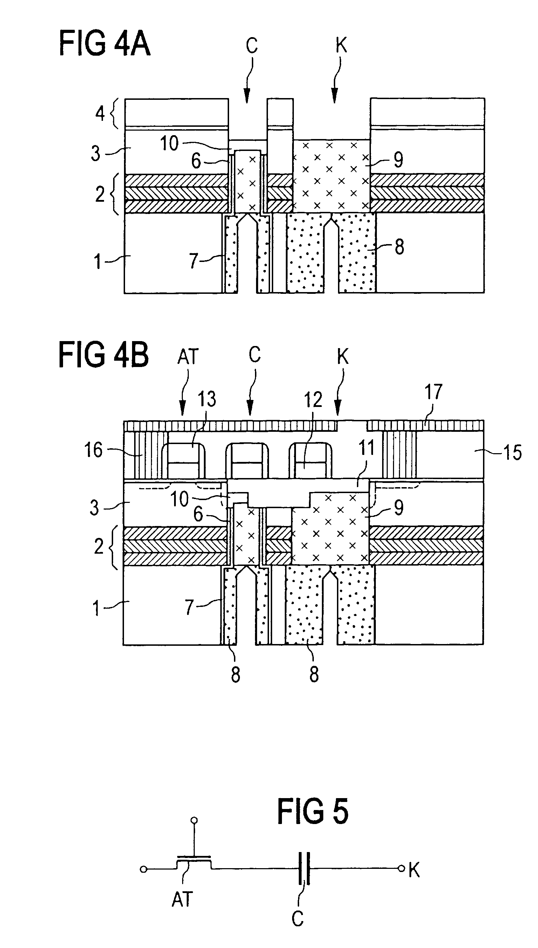

Figuren 4A und 4B zeigen vereinfachte Schnittansichten zur Veranschaulichung von Herstellungsschritten für einen Kontaktanschluss einer DRAM-Speicherzelle gemäß dem ersten Ausführungsbeispiel. Gleiche Bezugszeichen bezeichnen wiederum gleiche Elemente bzw. Schichten, weshalb nachfolgend auf eine wiederholte Beschreibung verzichtet wird.

Gemäß Figuren 4A und 4B sind zur Realisierung einer Kontaktierung der nicht dargestellten Außenelektrode des Speicherkondensators C keine weiteren Prozessschritte notwendig. Vielmehr kann der Kontakt K gleichzeitig mit den Grabenkondensatoren C ausgebildet werden und unter Verwendung von entsprechend angepassten Schichten bzw. einer entsprechend angepassten Grabenisolierung 11 sehr einfach hergestellt werden. Gemäß Figuren 4A und 4B wird hierbei sowohl das Kondensatordielektrikum 7 als auch die Diffusionsbarrierenschicht 6 vollständig aus dem erweiterten Graben für den Kontakt K entfernt. Gemäß Figuren 4A und 4B besitzt der in einem vergrößerten tiefen Graben ausgebildete Kontakt K eine Diffusionsbarrierenschicht 9 und eine innere Elektrodenschicht 8. Er kann jedoch auch ausschließlich aus der leitenden Diffusionsbarrierenschicht 9 bestehen oder darüber hinaus eine nicht dargestellte BS-Polysiliziumschicht aufweisen. Auf diese Weise erfolgt ein direkter Anschluss eines Halbleiterelements bzw. Grabenkondensators C in der weiteren Elementschicht 1 unter Verwendung des gleichen Prozesses.

Figur 5 zeigt ein Ersatzschaltbild der in Figur 4B dargestellten DRAM-Speicherzelle. Hierbei wird insbesondere durch die leitenden Diffusionsbarrierenschichten 9, die eine elektrische Verbindung des Grabenkondensators C zum Kontakt K und zum Auswahltransistor AT ermöglicht, eine Diffusion von Verunreinigungen zwischen der ersten Elementschicht 3 und der zumindest einen weiteren Elementschicht 1 verhindert.

Auf diese Weise erhält man Halbleiterschaltungen, die unter Verwendung von neuartigen Materialien problemlos bis zu einer Strukturgröße von unterhalb 100 nm skalierbar sind. Insbesondere bei Verwendung von Gräben zur Realisierung von Halbleiterelementen in den weiteren Elementschichten entfallen somit parasitäre vertikale Transistoren, weshalb keinerlei Leckströme zwischen diesen Bereichen auftreten und so beispielsweise eine Datenhaltezeit verbessert ist. Ferner erhöht sich die Leitfähigkeit im Graben, da durch Wegfall von bisher notwendigen Kragenisolationen ein höherer Querschnitt zur Verfügung steht. Ferner verringert sich die Komplexität des Gesamtprozesses, da insbesondere bei der Herstellung von DRAM-Speicherzellen keine Kragenisolationen und vergrabenen Platten ausgebildet werden müssen. Ferner ist das vorstehend beschriebene Herstellungsverfahren kompatibel mit den verschiedenen oberflächenvergrößernden Methoden wie z.B. HSG, Mesoporen und der bereits beschriebenen Grabenaufweitung. Insbesondere bei Verwendung eines leitenden Materials als erste Elementschicht erhält man eine höhere Kapazität, da auf der Seite der Außenelektrode keine Verarmungszone entsteht.

Die vorliegende Erfindung wurde insbesondere anhand einer DRAM-Speicherzelle beschrieben. Sie ist jedoch nicht darauf beschränkt und umfasst vielmehr alle weiteren Halbleiterschaltungen, in denen Hableiterelemente in unterschiedlichen Elementbereichen bzw. Elementschichten angeordnet sind und die Verwendung von inkompatiblen Materialien angestrebt ist.

## Patentansprüche

1. SOI-Substrat mit
einer ersten Elementschicht (3);
zumindest einer weiteren Elementschicht (1; 1'); und zumindest einer Isolationsschicht (2; 2') zwischen den Elementschichten (1; 1', 3)
**dadurch gekennzeichnet, dass** die Isolationsschicht (2; 2') eine Multilayer-Barrierenschicht mit einer Potentialbarriere und einer Diffusionsbarriere aufweist.

2. SOI-Substrat nach Patentanspruch 1,
**dadurch gekennzeichnet, dass** die Multilayer-Barrierenschicht (2) eine Vielzahl unterschiedlicher Isolationsschichten (2A, 2B, 2C) aufweist.

3. SOI-Substrat nach Patentanspruch 2,
**dadurch gekennzeichnet, dass** die Multilayer-Barrierenschicht (2) eine SiO₂/Si₃N₄/SiO₂-Schichtenfolge aufweist.

4. SOI-Substrat nach Patentanspruch 1,
**dadurch gekennzeichnet, dass** die Multilayer-Barrierenschicht (2') zumindest eine Isolationsschicht (2B') und zumindest eine leitende Schicht (2A') aufweist.

5. SOI-Substrat nach Patentanspruch 4,
**dadurch gekennzeichnet, dass** die Multilayer-Barrierenschicht (2') zumindest eine Ti-, TiSi-, Ta-, TaN-, TiN-, Pt-, Ru-, RuO-, Ir-, Mo-, Co-, Ni-, Hf-, Zr-, Ni-Si-, MoN-, HfN-, MoSi-, CoSi-, TaSi-, Au-, Ag-, Cu-, Al-, WSiN-, C, Fe, W-, WN- oder WSiₓ-Schicht oder Verbindungen aus diesen Materialien als leitende Schicht (2A') aufweist.

6. SOI-Substrat nach einem der Patentansprüche 1 bis 5,
**dadurch gekennzeichnet, dass** die weiteren Elementschichten eine isolierende Schicht (1'), oder eine halbleitende Schicht (1), oder eine leitende Schicht darstellen.

7. SOI-Substrat nach einem der Patentansprüche 1 bis 6,
**dadurch gekennzeichnet, dass** die Multilayer-Barrierenschicht (2; 2') ferner eine Thermo-Kompensationsschicht aufweist.

8. Verfahren zur Herstellung eines SOI-Substrats mit einer Vielzahl von Elementschichten bestehend aus den Schritten:
a) Ausbilden einer Elementschicht (1) und zumindest eines Teils einer Multilayer-Barrierenschicht (2; 2') auf einem ersten Wafer (W1);
b) Ausbilden einer Abspalt-Grenzschicht (3S) und von zumindest einem weiteren Teil der Multilayer-Barrierenschicht (2; 2') auf zumindest einem zweiten Wafer (W2);
c) Verbinden des ersten und zweiten Wafers (W1, W2) zum Ausbilden einer gemeinsamen Multilayer-Barrierenschicht (2; 2'), wobei die gemeinsame Multilayer-Barrierenschicht (2) eine Potential- und eine Diffusionsbarriere aufweist, und
d) Abspalten eines Teils (3*) des zumindest zweiten Wafers (W2) an der Abspalt-Grenzschicht (3S).

9. Verfahren nach Patentanspruch 8,
**dadurch gekennzeichnet, dass** der erste und zweite Wafer (W1, W2) ein Halbleitersubstrat aufweisen, wobei in Schritt a)
eine SiO₂/Si₃N₄/SiO₂-Schichtenfolge (2A, 2B, 2C) als Teil der Multilayer-Barrierenschicht (2) auf dem ersten Wafer (W1) ausgebildet wird, und in Schritt b) eine SiO₂-Schicht (2A) als weiterer Teil der Multilayer-Barrierenschicht (2) auf dem zweiten Wafer (W2) ausgebildet wird.

10. Verfahren nach Patentanspruch 8,
**dadurch gekennzeichnet, dass** der erste Wafer (W1) ein isolierendes Substrat und der zweite Wafer (W2) ein Halbleitersubstrat aufweist, wobei in Schritt a) eine leitende Schicht/SiO₂-Schichtenfolge als Teil der Multilayer-Barrierenschicht (2) auf dem ersten Wafer (W1) ausgebildet wird, und in Schritt b) eine SiO₂-Schicht als Teil der Multilayer-Barrierenschicht (2) auf dem zweiten Wafer (W2) ausgebildet wird.

11. Verfahren nach Patentanspruch 10,
**dadurch gekennzeichnet, dass** in Schritt a) eine Ti-, TiSi-, Ta-, TaN-, TiN-, Pt-, Ru-, RuO-, Ir-, Mo-, Co-, Ni-, Hf-, Zr-, NiSi-, MoN-, HfN-, MoSi-, CoSi-, TaSi-, Au-, Ag-, Cu-, Al-, WSiN-, C, Fe, W-, WN- oder WSiₓ-Schicht oder Verbindungen aus diesen Materialien als leitende Schicht ausgebildet wird.

12. Verfahren nach einem der Patentansprüche 8 bis 11,
**dadurch gekennzeichnet, dass** in Schritt c) das Verbinden des ersten und zweiten Wafers (W1, W2) mit einem Waferbondingverfahren durchgeführt wird.

13. Verfahren nach einem der Patentansprüche 8 bis 12,
**dadurch gekennzeichnet, dass** das Abspalten eines Teils (3*) des zumindest zweiten Wafers (W2) an der Abspalt-Grenzschicht (3S) mittels einer thermischen Behandlung durchgeführt wird.

14. Halbleiterschaltung in einem SOI-Substrat gemäß einem der Patentansprüche 1 bis 7,
**gekennzeichnet durch**
zumindest ein erstes Halbleiterelement (AT), welches in der ersten Elementschicht (3) ausgebildet ist; und
zumindest einem zweiten Halbleiterelement (C), welches in der zumindest zweiten Elementschicht (1, 1') ausgebildet ist, wobei das erste und zweite Halbleiterelement (AT, C) über eine leitende Diffusionsbarrierenschicht (9) elektrisch miteinander verbunden sind.

15. Halbleiterschaltung nach Patentanspruch 14,
**dadurch gekennzeichnet, dass** es eine DRAM-Speicherzelle darstellt, wobei das zumindest eine erste Halbleiterelement einen Auswahltransistor (AT) und das zumindest eine zweite Halbleiterelement einen Grabenkondensator (C) aufweist.

16. Verfahren zur Herstellung einer Halbleiterschaltung in einem SOI-Substrat gemäß einem der Patentansprüche 1 bis 7 mit den Schritten:
a) Ausbilden einer Maskenschicht (4; 4') entsprechend der verwendeten Multilayer-Barrierenschicht (2; 2');
b) Ausbilden eines tiefen Grabens (5) unter Verwendung der Maskenschicht (4; 4') bis in die zumindest weitere Elementschicht (1; 1');
c) Ausbilden von zumindest einem zweiten Halbleiterelement (C) in der weiteren Elementschicht (1; 1');
d) Ausbilden von zumindest einer leitenden Diffusionsbarrierenschicht (9) zum Anschließen des zumindest einen zweiten Halbleiterelements (C) und zum Verhindern einer Diffusion von Verunreinigungen in die erste Elementschicht (3); und
e) Ausbilden von zumindest einem ersten Halbleiterelement (AT) in der ersten Elementschicht (3).

17. Verfahren nach Patentanspruch 16,
**dadurch gekennzeichnet, dass** in Schritt c) ein Grabenkondensator (C) in der weiteren Elementschicht (1; 1') ausgebildet wird.

18. Verfahren nach einem der Patentansprüche 16 oder 17,
**dadurch gekennzeichnet, dass** in Schritt c) eine Grabenaufweitung des Grabens (5) in der weiteren Elementschicht (1; 1') durchgeführt wird.

19. Verfahren nach einem der Patentansprüche 16 bis 18,
**dadurch gekennzeichnet, dass** vor dem Ausbilden des zweiten Halbleiterelements (C ) eine isolierende Diffusionsbarrierenschicht (6) zum Verhindern einer Diffusion von Verunreinigungen in die erste Elementschicht (3) ausgebildet wird.

20. Verfahren nach einem der Patentansprüche 16 bis 19,
**dadurch gekennzeichnet, dass** ein Kontakt (K) der zweiten Elementschicht (1) durch Ausbilden eines vergrößerten tiefen Grabens ausgebildet wird.
